# EUROPÄISCHE PATENTSCHRIFT

(11) **EP 2 700 017 B1**
(45) Veröffentlichungstag und Bekanntmachung des Hinweises auf die Patenterteilung: **10.06.2015**
(21) Anmeldenummer: 12714711.4
(22) Anmeldetag: 19.04.2012
(51) Int. Cl.: G06F 13/42, H04L 12/64

(54) **VERFAHREN UND VORRICHTUNG ZUR SERIELLEN DATENÜBERTRAGUNG MIT UMSCHALTBARER DATENCODIERUNG**
METHOD AND DEVICE FOR SERIALLY TRANSFERRING DATA, HAVING SWITCHABLE DATA ENCODING
PROCÉDÉ ET DISPOSITIF POUR LA TRANSMISSION DE DONNÉES EN SÉRIE AVEC CODAGE DE DONNÉES À COMMUTATION

(30) Priorität: 20.04.2011 DE 102011007766
(43) Veröffentlichungstag der Anmeldung: 26.02.2014
(73) Patentinhaber: Robert Bosch GmbH, 70442 Stuttgart (DE)
(72) Erfinder: HARTWICH, Florian, 72762 Reutlingen (DE); LINDENKREUZ, Thomas, 72766Reutlingen (DE)
(86) Internationale Anmeldenummer: PCT/EP2012/057108
(87) Internationale Veröffentlichungsnummer: WO 2012/143411

(56) Entgegenhaltungen:
- DE-A1- 10 000 305
- DE-A1- 10 153 085
- DE-A1- 10 311 395
- DE-A1-102007 051 657
- CENA G ET AL: "Overclocking of controller area networks", ELECTRONICS LETTERS, IEE STEVENAGE, GB, Bd. 35, Nr. 22, 28. Oktober 1999 (1999-10-28), Seiten 1923-1925, XP006012867, ISSN: 0013-5194, DOI: 10.1049/EL:19991289

## Beschreibung

### Stand der Technik

Die Erfindung betrifft ein Verfahren sowie eine Vorrichtung zur Übertragung von Daten in Nachrichten oder Datenrahmen zwischen wenigstens zwei Teilnehmern eines Bussystems.

Beispielsweise aus der Offenlegungsschrift DE 100 00 305 A1 ist das Controller Area Network sowie eine als "Time Triggered CAN" (TTCAN) bezeichnete Erweiterung des CAN bekannt. Das beim CAN verwendete Medienzugriffssteuerverfahren beruht auf einer bitweisen Arbitrierung. Bei der bitweisen Arbitrierung können mehrere Teilnehmerstationen gleichzeitig Daten über den Kanal des Bussystems übertragen, ohne dass hierdurch die Datenübertragung gestört wird. Die Teilnehmerstationen können weiterhin beim Senden eines Bits über den Kanal den logischen Zustand (0 oder 1) des Kanals ermitteln. Entspricht ein Wert des gesendeten Bits nicht dem ermittelten logischen Zustand des Kanals, dann beendet die Teilnehmerstation den Zugriff auf den Kanal. Bei CAN wird die bitweise Arbitrierung üblicherweise in einem Arbitrierungsfeld innerhalb einer über den Kanal zu übertragenden Nachricht vorgenommen. Nachdem eine Teilnehmerstation das Arbitrierungsfeld vollständig an den Kanal gesendet hat, weiß sie, dass sie exklusiven Zugriff auf den Kanal hat. Somit entspricht das Ende der Übertragung des Arbitrierungsfelds einem Beginn eines Freigabeintervalls, innerhalb dessen die Teilnehmerstation den Kanal exklusiv nutzen kann. Gemäß der Protokollspezifikation des CAN dürfen andere Teilnehmerstationen so lange nicht auf den Kanal zugreifen, das heißt Daten an den Kanal senden, bis die sendende Teilnehmerstation ein Prüfsummenfeld (CRC-Feld) der Nachricht übertragen hat. Somit entspricht ein Endzeitpunkt der Übertragung des CRC-Felds einem Ende des Freigabeintervalls.

Durch die bitweise Arbitrierung wird eine zerstörungsfreie Übertragung der Nachrichten über den Kanal erreicht. Die auf dem CAN-Bus übertragenen Nachrichten werden auch Datenrahmen genannt. Durch die zerstörungsfreie Übertragung ergeben sich gute Echtzeiteigenschaften des CAN, wohingegen bei den Medienzugriffssteuerverfahren, bei denen die von einer Teilnehmerstation gesendeten Nachrichten aufgrund einer Kollision mit einer von einer anderen Station gesendeten weiteren Nachricht während der Übertragung über den Kanal zerstört werden kann, ein deutlich ungünstigeres Echtzeitverhalten haben, da es aufgrund der Kollision und der dadurch erforderlichen neuen Übertragung der Nachricht zu einer Verzögerung der Datenübertragung kommt.

Die Protokolle des CAN eignen sich besonders zum Übertragen kurzer Meldungen unter Echtzeitbedingungen. Sollen größere Datenblöcke über eine CAN-Domäne übertragen werden, dann wird die relativ geringe Bitrate des Kanals zu einem begrenzenden Faktor. Um die korrekte Funktion der bitweisen Arbitrierung zu gewährleisten, muss während der Arbitrierung für die Übertragung eines Bits eine in erster Linie von der Ausdehnung des Bussystems, der Signalausbreitungsgeschwindigkeit auf dem Kanal und intrinsischen Verarbeitungszeiten in den Schnittstellenmodulen der Busteilnehmer abhängige Mindestdauer eingehalten werden, denn alle Busteilnehmer müssen ein einheitliches Bild des Buszustands (0 oder 1) und gleichberechtigten Zugriff auf den Buszustand haben. Die Bitrate kann durch Verringern der Dauer der einzelnen Bits daher nicht ohne weiteres erhöht werden.

Um dennoch einen für die Programmierung einer Steuereinheit benötigten relativ großen Datenblock über eine eigentlich für den Anschluss an eine CAN-Domäne vorgesehene Kommunikationsschnittstelle hinreichend schnell übertragen zu können, schlägt die DE 101 53 085 A1 vor, die Kommunikationsschnittstelle zum Übertragen des Datenblocks vorübergehend in einen anderen Kommunikationsmodus umzuschalten, bei dem keine bitweise Arbitrierung durchgeführt wird und somit eine relativ hohe Bitrate möglich ist. Allerdings muss hierbei die Kommunikation mit den Protokollen des CAN für eine gewisse Zeit unterbrochen werden. Kann beispielsweise aufgrund eines Fehlers nicht mehr der Betrieb des Bussystems nach den CAN-Protokollen aufgenommen werden, dann kommt es zu einem Ausfall des Bussystems. Zudem kommt es durch die Übertragung eines relativ großen Datenblocks zu einer erheblichen Verzögerung der nachfolgenden gemäß den Protokollen des CAN vorzunehmenden Übertragungen, so dass die Echtzeiteigenschaften des CAN beeinträchtigt werden.

DE 103 11395 A1 beschreibt ein System, bei welchem die asynchrone, serielle Kommunikation alternativ über ein asymmetrisches physikalisches oder über das symmetrische physikalische CAN-Protokoll erfolgen kann, und dadurch eine höhere Datenübertragungsrate oder -Sicherheit für die asynchrone Kommunikation erzielbar ist.

DE 10 2007 051 657 A1 schlägt vor, in den exklusiven Zeitfenstern des TTCAN-Protokolles eine asynchrone, schnelle, nicht CAN-konforme Datenübertragung anzuwenden, um die übertragene Datenmenge zu erhöhen.

G. Cena und A. Valenzano behandeln in "Overclocking of controller area networks" (Electronics Letters, Vol. 35, No. 22 (1999), S. 1924) von theoretischer Seite die Auswirkungen einer Übertaktung der Busfrequenz in Teilbereichen der Nachricht auf die effektiv erzielte Datenrate, ohne jedoch auf Details der Methodik und die verschiedenen Zustände und Zustandsübergänge der Busteilnehmer einzugehen.

Es zeigt sich aus den zitierten Schriften, dass der Stand der Technik nicht in jeder Hinsicht befriedigende Ergebnisse liefert.

### Offenbarung der Erfindung

Die Erfindung beschreibt ein Verfahren, durch welches in einem CAN-Netzwerk Nachrichten in kürzerer Zeit übertragen werden können und gleichzeitig wesentliche Eigenschaften des CAN hinsichtlich Fehlererkennung und Fehlerbehandlung sowie netzwerkweite Datenkonsistenz erhalten bleiben. Hierzu wird ein gegenüber dem CAN-Protokoll nach ISO 11898-1 bis -4, das im Folgenden Norm-CAN genannt wird, modifiziertes Datenübertragungsverfahren, im Folgenden AC ("alternate coding")-CAN genannt, vorgeschlagen.

Die beschriebene Aufgabe wird durch dieses Datenübertragungsverfahren mit den Merkmalen des Anspruchs eins, sowie durch die in den unabhängigen Ansprüchen beschriebene Vorrichtung gelöst.

### Vorteile der Erfindung

Die beschriebene Aufgabe wird erfindungsgemäß dadurch gelöst, dass die Bitcodierung innerhalb einer Nachricht über mindestens zwei unterschiedliche Verfahren erfolgt, wobei für wenigstens einen ersten vorgebbaren Bereich innerhalb der ausgetauschten Nachrichten die Codierung der Bits nach dem Verfahren gemäß der CAN-Norm ISO 11898-1 erfolgt und bei Vorliegen einer Umschaltbedingung für wenigstens einen zweiten vorgebbaren Bereich innerhalb der ausgetauschten Nachrichten die Codierung der Bits nach einem von der CAN-Norm ISO 11898-1 abweichenden Verfahren erfolgt.

Ein Vorteil dieses Verfahrens ist, dass die logische Struktur der CAN-Nachrichten weitgehend, nämlich zumindest für den Bereich zwischen SOF und CRC-Delimiter erhalten bleibt. Die Schnittstelle zum Anwendungs-Programm kann dementsprechend unverändert bleiben. AC-CAN Controller können auch in Norm-CAN Netzwerken eingesetzt werden. In einem Netzwerk, das ausschließlich Teilnehmer mit AC-CAN Controllern umfasst, schalten alle Teilnehmer nach der Arbitrierung in den schnellen Modus, so dass alle Synchronisations- und Fehlererkennungsmechanismen weiter ihre Aufgabe erfüllen können. Es ist zudem vorteilhaft, dass die im zweiten Bereich verwendete Codierung so gewählt werden kann, dass eine erhöhte Datenübertragungsrate, eine erhöhte Datenübertragungssicherheit oder eine geringere Abstrahlung elektromagnetischer Wellen erreicht wird.

In vorteilhafter Weise wird bei Vorliegen der Umschaltbedingung in dem genannten zweiten Bereich eine NRZ-Codierung mit geringerem Spannungs-Hub und von der sendenden Teilnehmerstation schwach getriebenem rezessivem Pegel oder eine NRZI-Codierung, bei der das Auftreten einer Signalflanke als dominantes Bit interpretiert wird, verwendet. Ebenfalls vorteilhaft kann die Verwendung einer Frequenz- oder Amplitudenmodulation beziehungsweise - umtastung zur Darstellung der rezessiven und dominanten Bits sein. Besonders vorteilhaft ist es hierbei, wenn eine dritte Frequenz beziehungsweise Amplitude zur Signalisierung eines erkannten Fehlers in der Datenübertragung angewendet wird.

In einer besonders vorteilhaften Ausführungsform wird bei Vorliegen der Umschaltbedingung der elektrische Widerstand zwischen den Busleitungen durch schaltbare Widerstände an das Verfahren zur Bit-Codierung angepasst.

Es kann zudem vorteilhaft sein, parallel zu der Übertragung von Bits nach dem von der Norm abweichenden Verfahren auch Bits nach dem normgemäßen Codierungsverfahren zu übertragen.

Um den Vorteil zu erzielen, dass die Datenübertragungsrate erhöht wird, ist es möglich, in einem dritten Bereich, der vom zweiten Bereich umfasst wird oder mit ihm übereinstimmt, den Bustakt zu erhöhen, beispielsweise durch Anpassung eines Skalierungsfaktors zur Einstellung der Bus-Zeiteinheit relativ zu einer kleinsten Zeiteinheit oder dem Oszillatortakt.

Unter anderem zur Bewahrung der Fehlersicherheit ist es vorteilhaft, dass der zweite beziehungsweise dritte Bereich mit modifizierter Übertragung bei Erkennung eines Grundes zum Start eines Error-Frames oder bei Erreichen eines für die Rückumschaltung festgelegten Bits endet.

Vorteilhafterweise beginnt der zweite Bereich bei Vergabe des Buszugriffes durch Arbitrierung frühestens mit dem ersten Bit des Data Length Code und endet spätestens mit dem CRC Delimiter und das Vorliegen der Umschaltbedingung wird durch eine geeignete Kennzeichnung signalisiert, um busweite Datenkonsistenz für die korrekte Vergabe des Buszugriffes sicherzustellen. Bei zeitgesteuerter Buskommunikation kann es vorteilhaft sein, den zweiten Bereich auch schon früher beginnen zu lassen, frühestens mit dem Start of Frame-Bit.

Vorteilhaft ist es schließlich, wenn das Kommunikationsprotokoll dahingehend verändert wird, dass sendende Busteilnehmer zumindest bei Vorliegen einer Umschaltbedingung gegenüber der Spezifikation ISO 11898-1 eine um ein Bit zu späte Bestätigung (Acknowledge) des korrekten Empfanges einer Nachricht durch einen oder mehrere Empfänger und / oder einen maximal zwei Bit langen Acknowledge-Slot akzeptieren und nicht als Fehler behandeln. Dadurch wird vermieden, dass es zu unnötigen Fehlermeldungen kommt, wenn aufgrund von Signallaufzeiten oder internen Verarbeitungszeiten Zustandsübergänge zwischen den Übertragungsverfahren in verschiedenen Busteilnehmern zu nicht exakt übereinstimmenden Zeitpunkten stattfinden.

### Zeichnungen

Die Erfindung wird im Weiteren anhand der Zeichnungen näher erläutert.
Figur 1 zeigt schematisch ein Zustandsdiagramm mit den verschiedenen Zuständen, die ein AC-CAN Controller bezüglich des erfindungsgemäßen Verfahrens einnehmen kann, sowie den Übergangsbedingungen.
Figur 2 zeigt zwei Beispiele für mögliche Verfahren zur Bit-Codierung.
Figuren 3a und 3b zeigen schematisch den Aufbau von zur Darstellung des erfindungsgemäßen Verfahrens geeigneten Busanschlusseinheiten.
Figur 3c zeigt eine solche Busanschlusseinheit, die zusätzlich Mittel aufweist, um den elektrischen Widerstand zwischen den angeschlossenen Busleitungen an das Übertragungsverfahren anzupassen.
Figur 4 zeigt die Struktur einer CAN-Nachricht im Standard Format und im Extended Format mit der erfindungsgemäßen Aufteilung in Bereiche unterschiedlicher Bit-Codierung und mit der Kennzeichnung durch ein reserviertes Bit.
Figur 5 zeigt ein Beispiel für die Erweiterung des Bereiches reduzierter Bitlänge bei Kombination des Verfahrens mit dem zeitgesteuerten Übertragungsverfahren des TTCAN-Protokolls, dargestellt durch eine System-Matrix.
Figur 6 zeigt die eine Möglichkeit zur Aufteilung einer Nachricht in einem exklusiven TTCAN-Zeitfenster in Bereiche unterschiedlicher Bit-Codierung.
Figur 7 zeigt die gegenüber dem Stand der Technik erweiterten Akzeptanzkriterien für CRC-Delimiter oder Acknowledge-Bit bei Verwendung der alternativen Bit-Codierung.

### Beschreibung der Ausführungsbeispiele

Im Weiteren werden Ausführungsbeispiele für das erfindungsgemäße Verfahren und die Vorrichtung beschrieben. Diese konkreten Beispiele werden zur Erläuterung der Ausführung eingesetzt, beschränken aber nicht den Umfang des Erfindungsgedankens.

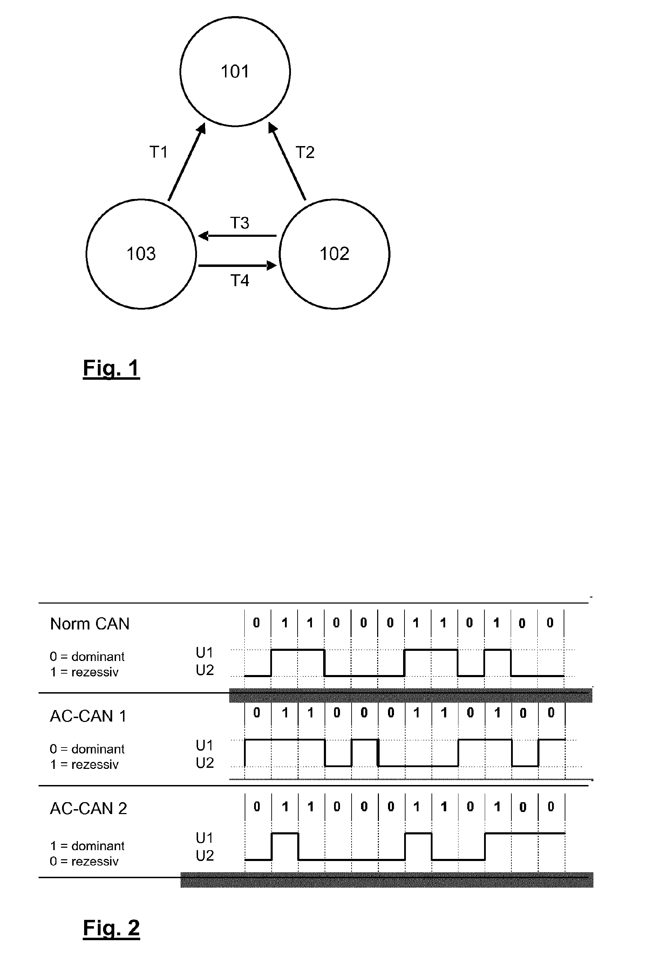

Zunächst werden in einem ersten Ausführungsbeispiels anhand der Figuren 1 bis 3 die Zustände des erfindungsgemäßen AC-CAN Controllers und die zugehörigen Datenübertragungs-Eigenschaften, sowie deren Übergänge und die hierfür notwendigen Übergangsbedingungen beschrieben.

Figur 1 stellt die drei Betriebs-Zustände des AC-CAN-Controllers dar: Norm-CAN 101, AC-CAN-Arbitration 102 und AC-CAN-Data 103. Im Betriebs-Zustand Norm-CAN 101 arbeitet er nach dem Norm-CAN Protokoll. Im Betriebs-Zustand AC-CAN-Arbitration 102 verhält er sich wie ein Norm-CAN Controller, kann aber auch in den AC-CAN-Data Zustand 103 wechseln. Im AC-CAN-Data Zustand 103 weicht sein Verhalten von dem eines Norm-CAN Controllers ab, denn die über den Bus zu übertragenden Bits werden nach einem alternativen Verfahren codiert. Der erfindungsgemäße Controller befindet sich nach dem Einschalten im AC-CAN-Arbitration Modus 102, wenn dies durch das Anwendungs-Programm angefordert wird. Andernfalls befindet er sich nach dem Einschalten im Norm-CAN Modus 101.

Als Teil der geänderten Bit-Codierung oder zusätzlich dazu kann auch im AC-CAN-Data Zustand 103 die Bustaktrate modifiziert werden. Es kann eine Veränderung des Skalierungsfaktors (Prescaler) zwischen Bustakt und dem Oszillatortakt im laufenden Betrieb vorgesehen werden. Dadurch wird die Länge der Bus-Zeiteinheiten eingestellt. In den Zuständen AC-CAN-Arbitration 102 und Norm-CAN 101 wird die lange Bus-Zeiteinheit verwendet, im Zustand AC-CAN-Data 103 die kurze Bus-Zeiteinheit. Die Zeitdauer, die insgesamt zur Übertragung der Daten, beispielsweise des Data Length Code, des Datenfeldes und des CRC-Feldes, im Zustand AC-CAN-Data benötigt wird, kann also unterschiedlich sein gegenüber der Zeitdauer, die bei normgemäßer Datenübertragung notwendig wäre.

In einem alternativen Ausführungsbeispiel können auch die Verwendung der alternativen Codierung der Bits und die Veränderung der Bustaktrate unabhängig voneinander erfolgen, sofern bei der verwendeten Codierung noch von einer Bustaktrate gesprochen werden kann, also die einzelnen Bits der Nachricht in zeitlicher Folge nacheinander übertragen werden. Das zu Figur 1 analoge Zustandsdiagramm ist dann entsprechend aufwändiger, denn es muss dann die verschiedenen Kombinationen der möglichen Änderungen des Übertragungsverfahrens (normale/modifizierte Codierung, normale/modifizierte Taktrate) und deren Übergänge enthalten. Im Folgenden wird von dem einfachen Zustandsdiagramm gemäß Figur 1 ausgegangen.

Im AC-CAN-Arbitration Zustand 102 wird beispielsweise als Kennzeichnung das "reserved bit" R0, das im CAN Frame vor dem Data Length Code DLC liegt, rezessiv gesendet. Im Norm-CAN Protokoll ist spezifiziert, dass dieses Bit dominant gesendet werden muss. Wenn ein AC-CAN Controller dieses Bit dominant empfängt und wenn dies durch das Anwendungs-Programm so eingestellt wurde, wechselt er dauerhaft in den Norm-CAN Zustand (Zustandswechsel T1 oder T2). Dadurch wird sichergestellt, dass AC-CAN und Norm-CAN Controller im selben Netz eingesetzt werden können und dann beide im Norm-CAN Protokoll arbeiten. Es kann auch ein anderes Bit als Kennzeichnung ausgewählt werden, für das im Norm-CAN Protokoll ein fester Wert spezifiziert ist. Ein anderes Umschalt-Kriterium, um dauerhaft in den Norm-CAN Zustand (Zustandswechsel T1 oder T2) zu wechseln, kann beispielsweise das Überschreiten eines bestimmten Standes der CAN-Fehler-Zähler sein.

Ein AC-CAN Controller im Zustand AC-CAN-Arbitration 102, der als Kennzeichnung beispielsweise das "reserved bit" R0 vor dem DLC rezessiv empfängt oder es erfolgreich rezessiv sendet, schaltet ab dem Sample-Point dieses Bits auf eine alternative Bit-Codierung um, beispielsweise eine NRZ (Non Return To Zero)-Codierung mit geringerem Spannungshub, und wechselt in den Zustand AC-CAN-Data 103 (Zustandswechsel T3). Zusätzlich erhöht er die Bustaktrate, indem er den Skalierungsfaktor umschaltet. Der Zustandswechsel kann auch mit einem zumindest näherungsweise konstanten Zeitabstand oder nach Ablauf einer definierten Anzahl von Bus-Zeiteinheiten nach dem Sample-Point erfolgen.

Ein AC-CAN Controller im Zustand AC-CAN-Data 103 bleibt in diesem Zustand, bis eine von zwei Bedingungen eintrifft:
(A) Er sieht einen Grund, einen CAN-Error-Frame zu starten, oder
(B) es wird im CAN-Frame der CRC-Delimiter erreicht.
Wenn (A) oder (B) erfüllt ist, schaltet der Controller zurück in den Zustand AC-CAN-Arbitration 102 (Zustandswechsel T4).

In dem Bereich zwischen DLC und CRC-Delimiter gibt es nach dem CAN-Protokoll zwei Gründe, einen Error-Frame zu starten: (A1) der Transmitter sieht einen Bit-Error oder (A2) ein Receiver sieht einen Stuff-Error. Diese Gründe sind unabhängig von der verwendeten Methode zur Bit-Codierung, die Fehlerüberwachungsmechanismen des CAN-Protokoll können diesbezüglich also weiterhin angewendet werden. Am Ende des evtl. überlagerten Error-Flags, dem Beginn des Error-Delimiters, sind alle Controller im Netzwerk im Zustand AC-CAN-Arbitration 102.

Sowohl in (A1) und (A2), als auch in (B) erfolgt der Wechsel T4 in den Zustand AC-CAN-Arbitration 102 und somit die Umschaltung des Skalierungsfaktors an dem Sample-Point, an dem die Bedingung eintrifft, oder mit einem zumindest näherungsweise konstanten Zeitabstand zu diesem. Der Zustandswechsel kann auch nach Ablauf einer definierten Anzahl von Bus-Zeiteinheiten nach dem Sample-Point erfolgen.

Eine wesentliche Eigenschaft der Bit-Codierung bei Signalübertragung über den Norm-CAN ist die Möglichkeit, dass jeder Busteilnehmer durch ein dominantes Bit alle rezessiven Bits anderer Busteilnehmer überschreiben kann. Im Norm-CAN wird diese Eigenschaft dadurch realisiert, dass sich der rezessive Pegel durch Fließen eines Entladestromes über definierte Abschlusswiderstände einstellt, während der dominante Pegel durch die Teilnehmer durch Treiben eines Stromes herbeigeführt wird. Diese Eigenschaft ermöglicht es jedem Busteilnehmer, sich an der Fehlerüberwachung zu beteiligen und bei Bemerken eines Fehlers in der Datenübertragung durch Versenden eines dominanten, aktiven Error-Flag (sechs aufeinanderfolgende dominante Bits, vgl. ISO 11898-1 Kap. 10.4.4.2) alle anderen Busteilnehmer ebenfalls in einen Fehlerzustand zu versetzen. Diese Eigenschaft ist bei der Auswahl geeigneter alternativer Verfahren zur Bit-Codierung beizubehalten.

Eine Alternative, die zur Reduktion der elektromagnetischen Abstrahlungen geeignet ist, ist die Verwendung einer NRZ-Codierung, die gegenüber der CAN-Norm einen geringeren Spannungs-Hub aufweist und zur Beschleunigung der Pegelwechsel mit schwach getriebenem rezessivem Pegel betrieben wird. Hierdurch werden gleichzeitig die notwendigen Zeiten zum Einstellen des jeweiligen Buspegels verkürzt und die fließenden Ströme und dadurch verursachten elektromagnetischen Felder klein gehalten. "Schwach getrieben" bedeutet in diesem Zusammenhang, dass zur Einstellung des rezessiven Pegels beispielsweise für kurze Zeit ein Strom durch den sendenden Teilnehmer getrieben wird, welcher parallel zum Entladestrom über die Abschlusswiderstände die Einstellung des rezessiven Pegels beschleunigt. Die durch den kurzen Stromfluss übertragene Ladungsmenge ist beispielsweise durch Einsatz von flankengetriggerten oder schwellwertgetriggerten Pulsgeneratoren oder durch eine geeignete Regelung oder Steuerung so zu begrenzen, dass weiterhin anderen Busteilnehmern die Möglichkeit bleibt, das rezessiv gesendete Bit im Fehlerfall durch ein dominantes Bit mit entsprechend stärkerem und/oder längerem Stromfluss in entgegengesetzter Richtung - also entgegen dem Entladestrom über die Abschlusswiderstände und dem zusätzlich vom rezessiv sendenden Busteilnehmer getriebenen Strom - zu überschreiben.

Eine andere mögliche Alternative zur NRZ-Bit-Codierung des Norm-CAN ist in Figur 2 schematisch in zwei verschiedenen Ausprägungen als Prinzipskizze dargestellt. Das dargestellte Verfahren, welches im Zustand AC-CAN-Data der erfindungsgemäßen AC-CAN-Controller zum Einsatz kommen könnte, ist eine Codierung gemäß einem NRZI(Non Return to Zero Invert)-Verfahren.

Im Beispiel AC-CAN 1 werden bei dem vorgeschlagenen Codierungsverfahren im Zustand AC-CAN-Data die Nullen innerhalb des Bitstroms, welche im Norm-CAN die dominanten Bits sind, als Flankenwechsel zwischen den Buspegeln beziehungsweise Differenzspannungen U1 und U2 dargestellt, während die Einsen, also die rezessiven Bits als gleichbleibende Pegel dargestellt werden. Jeder Teilnehmer kann bei Kenntnis des aktuellen Buszustands einen Flankenwechsel von U1 nach U2 oder in umgekehrter Richtung durch Treiben eines geeigneten Stromes erzwingen und somit rezessive Bits (bei denen kein Strom getrieben wird) der anderen Busteilnehmer überschreiben.

In dem alternativen Beispiel AC-CAN 2 werden im Zustand AC-CAN-Data die Einsen innerhalb des Bitstroms als Flankenwechsel zwischen den Buspegeln beziehungsweise Differenzspannungen U1 und U2 dargestellt, während die Nullen als gleichbleibende Pegel dargestellt werden. Sollen die Nullen wie gewohnt dominant übertragen werden, sich also gegenüber übertragenen Einsen durchsetzen können, kann in dieser Ausführungsform beispielsweise jeder Teilnehmer durch Herstellen einer niederohmigen Verbindung der beiden Busleitungen zu geeigneten Spannungsquellen, welche die aktuelle Differenzspannung U1 oder U2 aufrechterhalten, einen Flankenwechsel von U1 nach U2 oder in umgekehrter Richtung verhindern und somit rezessive Bits der anderen Busteilnehmer, bei denen ein Strom mit dem Ziel der Veränderung der Differenzspannung U1 oder U2 getrieben wird, überschreiben. Möglich wäre auch, die Einsen dominant und die Nullen rezessiv zu übertragen, wozu jedoch zusätzliche Anpassungen in der Protokollspezifikation notwendig wären.

Eine weitere Alternative ist der Einsatz einer Frequenzmodulation beziehungsweise Frequenzumtastung zur Codierung der Bits. In diesem Ausführungsbeispiel werden im Zustand AC-CAN-Data die dominanten und rezessiven Bits des Bitstroms der Nachricht als Signal mit wenigstens zwei unterschiedlichen Frequenzen, zum Beispiel FD und FR, dargestellt, welches auf die Busleitungen aufgebracht wird. Es können auch Frequenzkombinationen oder -bereiche zur Darstellung der beiden Bits verwendet werden. Die Frequenzen sind hierbei so wählen, dass sie ausreichend Abstand zueinander aufweisen, um sicher getrennt werden zu können. Die Amplituden, Frequenzen und die Leitungsanordnung sind so zu wählen, dass es nicht zu unzulässiger Abstrahlung von elektromagnetischen Wellen kommt. Hierzu sind insbesondere verdrillte Zweidrahtleitungen vorteilhaft, die eventuell zusätzlich abzuschirmen sind. Um sicherzustellen, dass sich ein dominantes Error-Flag auf dem Bus durchsetzt, kann zusätzlich eine dritte Frequenz FE festgelegt werden, welche beim Entdecken eines Fehlers gesendet wird. Hierdurch kann eine noch schnellere Verbreitung der Information, dass ein Fehler festgestellt wurde, erreicht werden.

Bei Einsatz einer Frequenzmodulation als Bit-Codierungsverfahren kann es auch vorteilhaft sein, jeweils mehrere zu sendende Bits einer Nachricht zusammenzufassen und in eine Frequenzinformation umzuwandeln. Beispielsweise können je zwei Bits zusammengefasst werden und vier verschiedene Frequenzinformationen, insbesondere einzelne Frequenzen, Frequenzkombinationen oder Frequenzgruppen, zur Darstellung der vier möglichen Werte der zwei Bits verwendet werden. Bei Zusammenfassung von jeweils drei Bits sind entsprechend acht verschiedene Frequenzen, Frequenzkombinationen oder -gruppen nötig, allgemein bei Zusammenfassung von N Bits sind 2^{N} unterschiedliche Frequenzinformationen zur Abbildung nötig. Im Empfänger wird dann die empfangene Frequenzinformation wieder in die serielle Bitfolge umgewandelt, so dass die nachfolgende Verarbeitung im Wesentlichen unverändert erfolgen kann.

In einer weiteren möglichen Ausführungsform kann in diesem Fall das Bit-Stuffing aus dem Norm-CAN für den Bereich, in dem eine Frequenzmodulation als alternatives Codierungsverfahren genutzt wird, ausgesetzt werden. Das Stuffing (vgl. ISO 11898-1 Kap. 10.5) verhindert in der Norm-CAN-Datenübertragung das Auftreten von mehr als fünf aufeinander folgenden Bits mit gleichem Buspegel durch Einstreuen von zusätzlichen, entgegengesetzten Bits und stellt dadurch unter anderem sicher, dass in nicht zu großen Abständen Flanken zur Synchronisierung des Bit-Timings der verschiedenen Busteilnehmer auf dem Bus zur Verfügung stehen. Bei Anwendung des Frequenzmodulationsverfahrens kann in manchen Ausführungsformen nicht mehr von aufeinander folgenden Bits mit gleichem Buspegel gesprochen werden. Dementsprechend ist das Einfügen von Stuff-Bits durch den jeweiligen Sender in dem Bereich, in dem eine Frequenzmodulation als alternatives Codierungsverfahren angewendet wird, dann nicht mehr notwendig. In den Empfängern ist der Empfangsprozess für diesen Bereich analog anzupassen.

Ebenfalls möglich ist es, eine Amplitudenmodulation beziehungsweise Amplitudenumtastung zur Codierung der Bits anzuwenden. In diesem Ausführungsbeispiel werden im Zustand AC-CAN-Data die dominanten und rezessiven Bits des Bitstroms der Nachricht als Signal vorgegebener Frequenz F0 mit wenigstens zwei unterschiedlichen Amplituden, zum Beispiel AD und AR, dargestellt, welches auf die Busleitungen aufgebracht wird. Es können auch Amplitudenbereiche zur Darstellung der beiden Bits verwendet werden. Die Amplituden sind in diesem Fall so wählen, dass sie ausreichend Abstand zueinander aufweisen, um sicher unterschieden werden zu können. Die Grundfrequenz F0 und die Leitungsanordnung sind so zu wählen, dass es nicht zu unzulässiger Abstrahlung von elektromagnetischen Wellen kommt. Hierzu sind insbesondere verdrillte Zweidrahtleitungen vorteilhaft, die eventuell zusätzlich abzuschirmen sind. Um sicherzustellen, dass sich ein dominantes Error-Flag auf dem Bus durchsetzt, kann zusätzlich eine dritte Amplitude AE, insbesondere eine besonders hohe Amplitude festgelegt werden, welche beim Entdecken eines Fehlers gesendet wird. Hierdurch kann wiederum eine noch schnellere Verbreitung der Information, dass ein Fehler festgestellt wurde, erreicht werden.

Es können auch weitere dem Fachmann bekannte Codierungsverfahren beziehungsweise Modulationsverfahren zum Einsatz kommen. In jedem Fall ist für die gewählte Bit-Codierung analog den zuvor geschilderten Ausführungsbeispielen ein Mechanismus einzuführen, der es den Busteilnehmern erlaubt, das rezessiv gesendete Bit eines nach der Arbitrierung sendeberechtigten Busteilnehmers im Fehlerfall durch ein dominantes Bit beziehungsweise ein aus mehreren dominanten Bits bestehendes Error-Flag zu überschreiben.

Der erfindungsgemäße AC-CAN Controller muss in Verbindung mit einer oder mehreren geeigneten Busanschlusseinheiten beziehungsweise Transceivern die unterschiedlich codierten Signale über die Busleitungen übertragen. Hier sind verschiedene Anordnungen möglich.

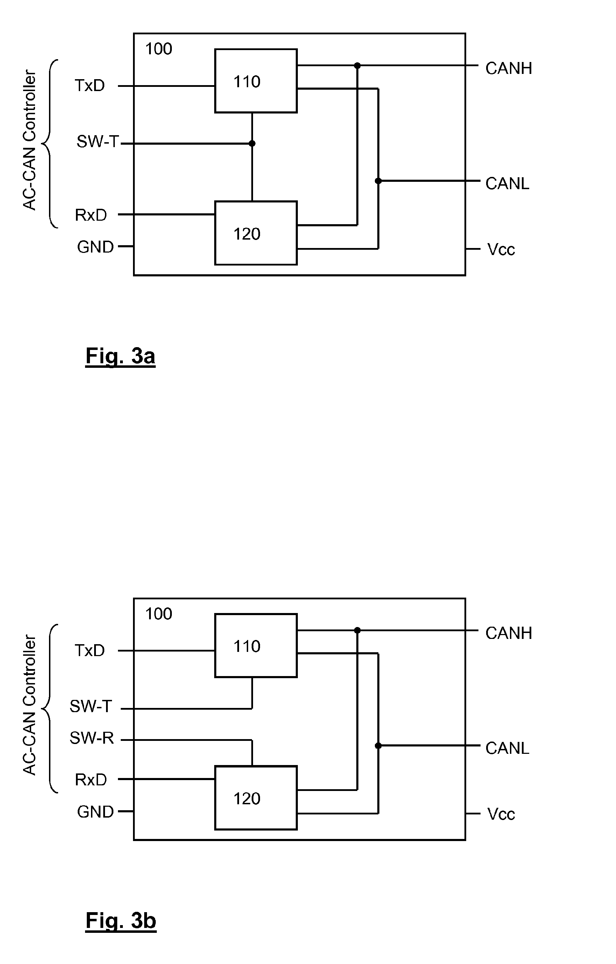

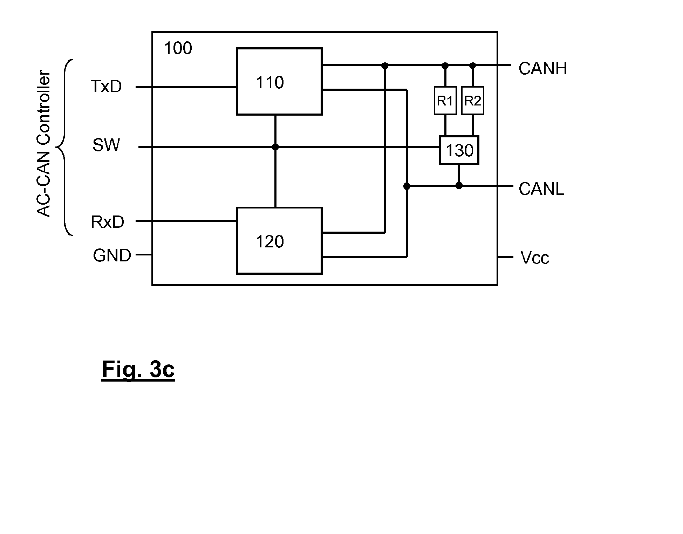

In Figur 3a ist beispielhaft ein Blockschaltbild einer zugehörigen Busanschlusseinheit 100 beziehungsweise eines AC-CAN Transceivers dargestellt. Die Vorrichtung weist eine Schaltung mit Schaltungselementen auf, welche sich in einen Sendeteilschaltung 110 und eine Empfangsteilschaltung 120 unterteilen lässt. Die Sende- und Empfangsteilschaltung können miteinander in Verbindung stehen oder auch gemeinsame Schaltungselemente aufweisen. Die Vorrichtung weist weiterhin die notwendigen Anschlussmöglichkeiten auf, insbesondere die Anschlüsse CANH, CANL für den Busanschluss, die Anschlüsse RxD und TxD zum Empfang und Senden von logischen Daten von bzw. an den AC-CAN-Controller, den Anschluss Vcc zur Bereitstellung einer Versorgungsspannung, sowie GND zur Bereitstellung einer Erdung. Weitere mögliche Anschlüsse können gemäß dem Stand der Technik beispielsweise umfassen: Enable-Eingänge, Wakeup-Eingänge, Standby-Eingänge etc. Diese wurden hier der Einfachheit halber weggelassen. Die Sendeteilschaltung 110 erzeugt basierend auf zumindest dem Sendesignal TxD des AC-CAN-Controllers Ausgangssignale für die Busanschlüsse CANH und CANL. Die Empfangsteilschaltung 120 erzeugt basierend auf zumindest der Differenz der Eingangssignale der Busanschlüsse CANH und CANL ein Empfangssignal RxD für den AC-CAN-Controller.

Im in Figur 3a dargestellten Fall generiert der AC-CAN Controller das serielle Bit-Signal und gibt es über die Leitung TxD an den Transceiver 100. Im Zustand AC-CAN Data ist das über die Leitung TxD übermittelte Signal beispielsweise nach einem NRZI-Verfahren codiert und wird mit höherer Taktrate übertragen. Der im Beispiel dargestellte Transceiver 100 ist über die Switch-Leitung SW vom AC-CAN Controller umschaltbar, so dass er je nach Codierungsverfahren die entsprechenden Spannungspegel auf den Busleitungen erzeugt. Diese Anordnung ist beispielsweise für die Anwendung einer NRZ-Codierung, die gegenüber der CAN-Norm einen geringeren Spannungs-Hub aufweist, oder einer NRZI-Codierung möglich.

Optional kann der AC-CAN-Controller auch, wie in Figur 3b dargestellt, über getrennte Switch-Leitungen SW-R und SW-T mit dem Transceiver 100 verbunden sein, um ihn gezielt in den Zustand "AC-CAN Transmit" oder "AC-CAN-Receive" zu schalten. Falls die Codierung z.B. darin besteht, dass der rezessive Pegel vom sendenden Busteilnehmer schwach getrieben wird und dass von den Busteilnehmern im Empfangspfad leicht unterschiedliche Schwell-Werte oder Filter eingesetzt werden, ist es sinnvoll, den Transceiver getrennt in die Zustände "AC-CAN Transmit" oder "AC-CAN-Receive" zu schalten, da ein empfangender Busteilnehmer zwar die anderen Schwell-Werte oder Filter verwenden soll, aber den rezessiven Pegel nicht ebenfalls schwach treiben soll, da sonst der resultierende, von mehreren Busteilnehmern getriebene rezessive Pegel nicht mehr durch ein dominantes Bit überschrieben werden könnte.

In anderen Fällen, beispielsweise bei der Verwendung einer Amplituden- oder Frequenzumtastung oder -modulation wird auch eine andere Anordnung in Betracht kommen, bei welcher eine separate Busanschlusseinheit, etwa ein separater Transceiver zur Erzeugung der modulierten Wechselspannung und zu deren Aufbringung auf die Busleitungen herangezogen wird, wobei diese Busanschlusseinheit oder dieser Transceiver vom AC-CAN Controller über separate Verbindungen angesteuert wird. Der AC-CAN Controller kann hierzu optional einen zweiten RxD-Eingang haben, an den der Ausgang eines zweiten, separaten AC-CAN-Transceivers angeschlossen wird, während die Ansteuerung im Sendefall über einen mit beiden Transceivern verbundenen TxD-Ausgang erfolgt. Es können aber auch sowohl TxD-Ausgang, als auch RxD-Eingang für jeden verbundenen Transceiver separat vorgesehen sein.

Es kann in allen geschilderten Codierungsvarianten sinnvoll sein, die definierten Abschlusswiderstände des Norm-CAN durch schaltbare Abschlusseinheiten, beispielsweise schaltbare Widerstände in den Busanschlusseinheiten, welche in Verbindung mit den AC-CAN Controllern stehen, zu ersetzen. Auf diese Weise kann im Zustand AC-CAN-Data der wirkende Widerstandswert modifiziert werden, oder es können die Widerstände vollständig von der Busleitung getrennt werden.

Die Abschlusswiderstände sind in Norm-CAN Netzwerken typischerweise als zwei Widerstände von je 120 Ohm im Bereich der Leitungsenden oder an zwei relativ weit voneinander entfernten Busteilnehmern ausgeprägt. In einem Bussystem, in welchem das erfindungsgemäße Verfahren zur Anwendung kommt, können die Abschlusswiderstände über viele oder alle Busteilnehmer verteilt werden, wobei die individuellen Widerstandswerte je Busteilnehmer entsprechend anzupassen sind. Die erfindungsgemäßen AC-CAN Controller oder zugehörigen Busanschlusseinheiten oder Transceiver werden durch einen geeigneten Ausgang in die Lage versetzt, eine Umschaltung zwischen wenigstens zwei verschiedenen Abschlusseinheiten, beispielsweise Widerständen, welche zwischen den Busleitungen angeordnet sind vorzunehmen.

In Figur 3b ist ein Blockschaltbild einer zugehörigen Busanschlusseinheit beziehungsweise eines AC-CAN Transceivers dargestellt, dessen Switch-Eingang SW zusätzlich mit einem Schaltelement 130 verbunden ist. Das Schaltelement ist einerseits mit dem Busanschluss CANL verbunden, andererseits mit beispielsweise zwei verschiedenen Widerständen R1 und R2, welche wiederum mit dem Busanschluss CANH in Verbindung stehen. Das Schaltelement kann somit abhängig von einem Steuersignal, welches am Switch-Eingang SW anliegt, den ohmschen Widerstand zwischen den Busleitungen verändern.

Für angenommene 50 Teilnehmer, jeweils ausgestattet mit AC-CAN Controllern und AC-CAN Transceivern, an einem Bussystem könnten beispielsweise in jedem Teilnehmer zwei schaltbare Widerstände von R1 = 6 kOhm und R2 = 60 kOhm vorgesehen werden. Durch die Schaltbarkeit kann dann erreicht werden, dass in den Zuständen AC-CAN-Arbitration und Norm-CAN wie gewohnt ein Widerstand von 1/50 x 6 kOhm, also 120 Ohm zwischen den Busleitungen vorliegt, dass jedoch im Zustand AC-CAN-Data der Widerstand durch Umschalten in allen Busteilnehmern beispielsweise verzehnfacht würde. Beliebige andere Widerstandswerte sind analog darstellbar. Der sendende Busteilnehmer muss dann im Zustand AC-CAN-Data beim Aufbau des vorgesehenen Spannungspegels nicht gegen den Entladestrom über die Abschlusswiderstände arbeiten und kann so schneller die Zielspannung aufbauen. Um eine flexible Einsetzbarkeit in Bussystemen mit unterschiedlichen Anzahlen von Busteilnehmern zu ermöglichen, könnten die Werte der schaltbaren Widerstände durch geeignete Mittel konfigurierbar ausgeführt werden.

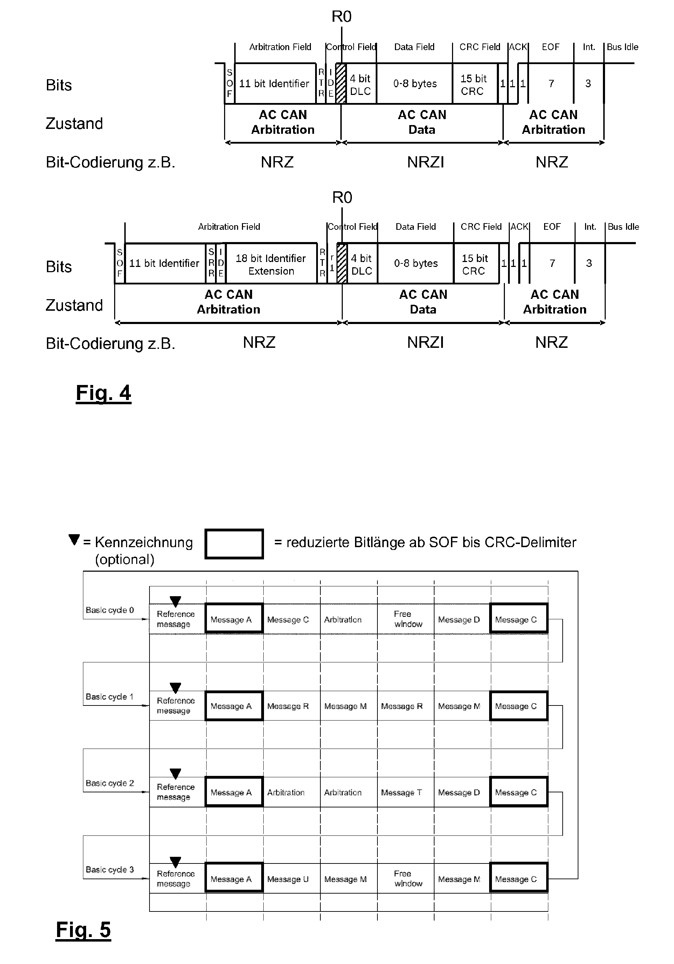

Anhand Figur 4 wird im Folgenden der Aufbau der verwendeten Nachrichten, insbesondere die Bereiche mit unterschiedlicher Codierung der Bits in Abhängigkeit vom jew. Zustand des Controllers und die erfindungsgemäße Kennzeichnung erläutert.

Figur 4 zeigt die Struktur einer CAN-Nachricht gem. ISO 11898-1 in den zwei möglichen Varianten, dem Standard Format und dem Extended Format. Für beide Varianten sind die Bereiche eingezeichnet, in denen erfindungsgemäß zwischen den Zuständen AC-CAN-Arbitration 102 und AC-CAN-Data 103 umgeschaltet wird. Ebenfalls dargestellt ist die damit einhergehende Umschaltung der verwendeten Bitcodierung, im dargestellten Beispiel vom normgemäßen NRZ-Verfahren auf ein NRZI-Verfahren. Andere mögliche Verfahren wurden bereits weiter oben aufgezählt. Schließlich wird noch die in diesem Ausführungsbeispiel gewählte Position der erfindungsgemäßen Kennzeichnung im "reserved bit" R0, das vor dem DLC übertragen wird, dargestellt. Eine andere mögliche Kennzeichnung ist etwa für Extended Format Botschaften durch das SRR-Bit gegeben.

Das erste dargestellte Ausführungsbeispiel für das erfindungsgemäße Verfahren ist also ein Übertragungsverfahren, in welchem nach erfolgter Arbitrierung derjenige Busteilnehmer, der den Buszugriff erfolgreich erlangt hat, ab einem vorgegebenen oder vorgebbaren Bit der Nachricht die Übertragung der weiteren Bits der Nachricht durch Umschaltung auf eine geänderte Bit-Codierung so durchführt, dass die zu übertragenden Bits schneller übertragen werden und / oder die Übertragung störsicherer ist und / oder die bei der Übertragung entstehenden elektromagnetischen Wellen reduziert sind. Dieses erste Ausführungsbeispiel steht stellvertretend für eine ganze Gruppe von Ausführungsformen, in denen die Umschaltung auf die geänderte Bit-Codierung erst nach erfolgter Arbitrierung durchgeführt wird. Für die anzuwendende Bit-Codierung gibt es hierbei, wie dargestellt, vielfältige Möglichkeiten.

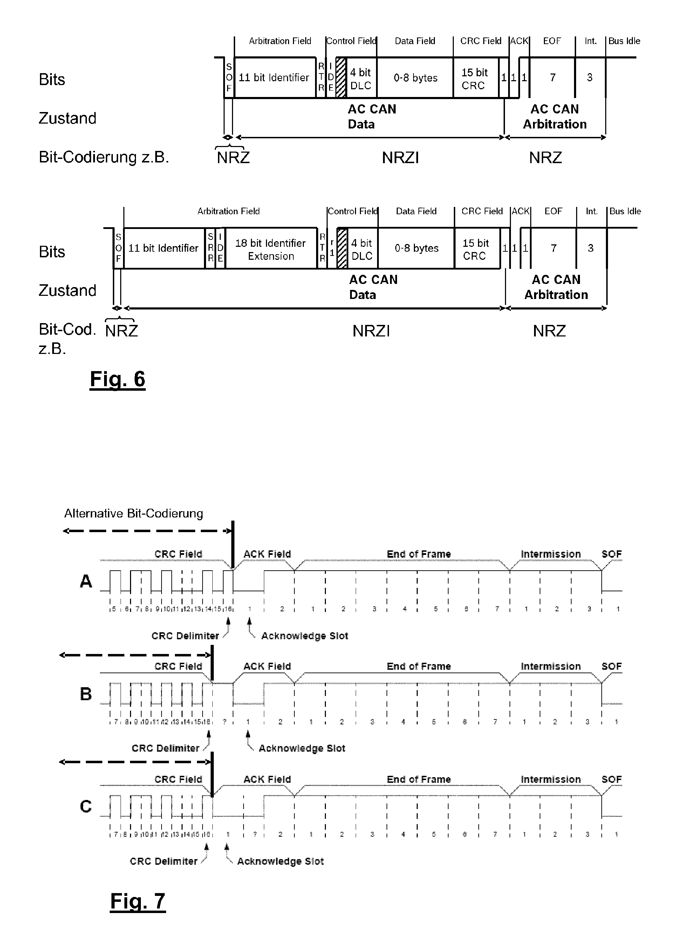

Ein zweites Ausführungsbeispiel für das erfindungsgemäße Verfahren, welches stellvertretend für eine zweite Gruppe von Ausführungsformen steht, wird im Folgenden anhand der Figuren 5 und 6 dargestellt. Es zeichnet sich dadurch aus, dass durch eine Zeitsteuerung zumindest für einige der erfindungsgemäß modifizierten Nachrichten gleichzeitige Sendeversuche unterbunden werden und dementsprechend schon früher innerhalb der entsprechenden Nachrichten auf eine alternative, beispielsweise schnellere Codierung der Bits umgeschaltet werden kann. Insbesondere kann diese Umschaltung schon während der Übertragung des Arbitrationsfeldes erfolgen.

Figur 5 zeigt hierzu eine System-Matrix eines TTCAN-Netzwerkes gem. ISO11898-4 mit den dort beschriebenen Basiszyklen und Zeitfenstern. Es gibt Zeitfenster, die mit "Message A", "Message C", etc. bezeichnet sind, die exklusiv für die Übertragung bestimmter Nachrichten zur Verfügung stehen, während in anderen Zeitfenstern, die mit "Arbitration" bezeichnet sind, der Buszugriff durch gewöhnliche CAN-Arbitirierung vergeben wird.

Im zweiten Ausführungsbeispiel werden alle Nachrichten, für die nichts anderes beschrieben ist, gemäß dem Verfahren aus dem ersten Ausführungsbeispiel behandelt. Darüber hinaus wird für bestimmte, vorab festgelegte, exklusiv vergebene Zeitfenster eine Umschaltung der Bit-Codierung schon früher, beispielsweise ab dem SOF-Bit vorgenommen und beispielsweise bis zum Ende des CRC-Feldes aufrechterhalten. Ein Beispiel für eine derartig modifiziert übertragene Nachricht ist in Figur 5 dargestellt. Als Kennzeichnung für die bevorstehende modifizierte Übertragung kann beispielsweise ein reserviertes Bit der vorangehenden Referenzbotschaft herangezogen werden. Das Setzen dieses Bits würde im beschriebenen Fall signalisieren, dass die Nachrichten, die im folgenden Basiszyklus in exklusiven Zeitfenstern übertragen werden, bereits ab dem SOF-Bit und bis zum Ende des CRC-Feldes mit umgeschalteter Bit-Codierung, beispielsweise nach einem NRZI-Verfahren oder über Amplituden- oder Frequenzumtastung übertragen werden.

In einer anderen Ausführungsform ist es denkbar, dass lediglich diejenigen exklusiven Nachrichten, die in jedem Basiszyklus, also mit Wiederholungsfaktor eins übertragen werden, durch das Verfahren modifiziert übertragen werden. Dieser Fall ist explizit in Figur 5 dargestellt. In der beispielhaft dargestellten System-Matrix würden dann die mit "Message A" und "Message C" bezeichneten Nachrichten nach dem erläuterten Verfahren übertragen werden, mit einer entsprechenden Kennzeichnung in der jeweils vorangehenden Referenzbotschaft.

Für das im zweiten Ausführungsbeispiel beschriebene Verfahren ist es auch möglich, auf die Kennzeichnung zu verzichten und festzulegen, dass in allen exklusiven Zeitfenstern die Nachrichten grundsätzlich in einem festgelegten Bereich wie zum Beispiel zwischen SOF-Bit und dem Ende des CRC-Feldes mit modifizierter Bit-Codierung übertragen werden. Aus diesem Grund ist in Figur 5 die Kennzeichnung mit dem Hinweis "optional" versehen.

Da die Umschaltung der Bit-Codierung im Zustand AC-CAN-Data auch mit einer schnelleren Übertragung der Bits beziehungsweise einer Erhöhung des Bustaktes einhergehen kann, verändert sich auch die Zeitdauer, die zur Übertragung der zugehörigen Bits benötigt wird. Durch Oszillatorungenauigkeiten und Abweichungen in den exakten Umschaltzeitpunkten kann es nötig sein, ein gegenüber dem in der ISO 11898-1 spezifizierten Verfahren modifiziertes Verfahren für die Behandlung der Sendebestätigung (CRC-Delimiter und Acknowledge-Slot) anzuwenden, wie in Figur 7 näher erläutert wird.

In Figur 7 unter "A" dargestellt ist der ideale Ablauf des Überganges vom Zustand AC-CAN-Data nach AC-CAN-Arbitration bei sehr kurzen internen Verarbeitungs- und Signallaufzeiten. Der Sender sendet den CRC-Delimiter als ein einziges, rezessives Bit und wechselt gemäß den vorausgehend beschriebenen Ausführungsbeispielen der vorliegenden Erfindung beispielsweise am Sample-Point dieses CRC-Delimiter Bits oder nach Verstreichen einer festgelegten Zeit danach in den AC-CAN-Arbitration Zustand. Auch die Empfänger wechseln beispielsweise an dieser Bit-Position in den Zustand AC-CAN-Arbitration. Diese Zustandsübergänge T4 können, etwa aufgrund von Signallaufzeiten oder internen Verarbeitungszeiten, in den verschiedenen Busteilnehmern zu nicht exakt übereinstimmenden Zeitpunkten stattfinden. Die beteiligten Busteilnehmer setzen also zu nicht exakt übereinstimmenden Zeitpunkten das Verfahren zur Bit-Codierung wieder in den Ausgangszustand. Daraus resultieren für die Busteilnehmer unterschiedliche Startzeitpunkte des nächsten Bits.

Nach Empfang des CRC-Delimiter sendet jeder Empfänger, wenn sein CRC-Check positiv war, ein einzelnes dominantes Acknowledge-Bit. Geschieht dies relativ spät, weil beispielsweise die Empfänger an entfernten Enden des Busses angeschlossen sind, kann das rezessive CRC-Delimiter-Bit länger als ein Bit erscheinen. Dieser Fall ist in Figur 7 unter "B" dargestellt. Durch Überlagerung von Acknowledge-Bits kann zudem der Acknowledge-Slot länger als ein Bit erscheinen, wie in Figur 7 unter "C" dargestellt ist. Um die phasenverschobenen Sendezeitpunkte dieser Acknowledge-Bits gegebenenfalls auszugleichen, kann die Behandlung dieser Bits in AC-CAN Controllern dahingehend verändert werden, dass im Zustand AC-CAN-Arbitration ein dominanter Acknowledge-Slot von ein oder zwei Bit Länge, der direkt nach dem CRC-Delimiter oder auch ein Bit später beginnt, als gültiges Acknowledge anerkannt wird.

Durch die fallende Flanke des Acknowledge-Bit sind anschließend die Busteilnehmer im Rahmen des üblichen Resynchronisations-Mechanismus wieder synchronisiert. Wenn vom Sender nach dem ersten Bit des CRC-Delimiters nicht nur ein, sondern zwei weitere rezessive Bits empfangen werden, ist dies für ihn ein Acknowledge-Error. Wenn nach dem zweiten dominanten Acknowledge-Bit ein drittes dominantes Bit empfangen wird, ist dies für alle ein Format-Error.
Auf den Acknowledge-Slot folgt, wie im Norm-CAN, ein rezessiver Acknowledge-Delimiter, der ein Bit lang ist. Wie im Norm-CAN wird ein AC-CAN Empfänger, der einen CRC-Fehler erkannt hat, den Error-Frame erst in dem Bit nach dem Acknowledge-Delimiter starten.

Zusammenfassend liegt durch die dargestellte Erfindung ein Verfahren vor, durch welches in einem CAN-Netzwerk Nachrichten durch eine geänderte Bit-Codierung in kürzerer Zeit und / oder unter reduzierter Abstrahlung von elektromagnetischen Wellen und / oder mit höherer Störsicherheit übertragen werden können und gleichzeitig wesentliche Eigenschaften des CAN hinsichtlich Fehlererkennung und -Behandlung sowie netzwerkweite Datenkonsistenz erhalten bleiben.

## Patentansprüche

1. Verfahren zur Datenübertragung in einem Netzwerk mit mindestens zwei Datenverarbeitungseinheiten, die über das Netzwerk Nachrichten austauschen, wobei die ausgetauschten Nachrichten eine logische Struktur gemäß der CAN-Spezifikation ISO 11898-1 aufweisen,
wobei für wenigstens einen ersten vorgebbaren Bereich innerhalb der ausgetauschten Nachrichten die Codierung der Bits nach dem Verfahren gemäß der CAN-Norm ISO 11898-1 erfolgt,
**dadurch gekennzeichnet, dass** bei Vorliegen einer Umschaltbedingung für wenigstens einen zweiten vorgebbaren Bereich innerhalb der ausgetauschten Nachrichten die Codierung der Bits nach einem von der CAN-Norm ISO 11898-1 abweichenden Verfahren erfolgt.

2. Verfahren gemäß Anspruch 1,
**dadurch gekennzeichnet, dass** die im zweiten Bereich verwendete Codierung der Bits so gewählt ist, dass eine erhöhte Sicherheit gegenüber externen Störungen und / oder eine geringere Abstrahlung von elektromagnetischen Wellen erreicht wird.

3. Verfahren gemäß Anspruch 1 oder 2,
**dadurch gekennzeichnet, dass** die im zweiten Bereich verwendete Codierung eine NRZ-Codierung ist, die gegenüber der CAN-Norm einen geringeren Spannungs-Hub aufweist und bei der der rezessive Pegel schwach getrieben wird.

4. Verfahren gemäß Anspruch 1 oder 2,
**dadurch gekennzeichnet, dass** im zweiten Bereich zur Codierung der Bits eine NRZI-Codierung verwendet wird, wobei das Auftreten einer Signalflanke als dominant und das Ausbleiben einer Flanke als rezessiv interpretiert wird.

5. Verfahren gemäß Anspruch 1 oder 2,
**dadurch gekennzeichnet, dass** im zweiten Bereich zur Codierung der Bits eine Frequenzmodulation oder Frequenzumtastung angewendet wird, wobei eine erste Frequenz oder Gruppe von Frequenzen oder ein erster Frequenzbereich als dominant und eine zweite Frequenz oder Gruppe von Frequenzen oder ein zweiter Frequenzbereich als rezessiv interpretiert wird.

6. Verfahren gemäß Anspruch 5,
**dadurch gekennzeichnet, dass** im zweiten Bereich eine dritte Frequenz oder Gruppe von Frequenzen oder ein dritter Frequenzbereich zur Signalisierung eines erkannten Fehlers in der Datenübertragung angewendet wird.

7. Verfahren gemäß Anspruch 1 oder 2,
**dadurch gekennzeichnet, dass** im zweiten Bereich zur Codierung der Bits eine Amplitudenmodulation oder Amplitudenumtastung angewendet wird, wobei eine erste Amplitude oder ein erster Amplitudenbereich als dominant und eine zweite Amplitude oder ein zweiter Amplitudenbereich als rezessiv interpretiert wird.

8. Verfahren gemäß Anspruch 7,
**dadurch gekennzeichnet, dass** im zweiten Bereich eine dritte Amplitude oder ein dritter Amplitudenbereich zur Signalisierung eines erkannten Fehlers in der Datenübertragung angewendet wird.

9. Verfahren gemäß einem der Ansprüche 1 bis 8,
**dadurch gekennzeichnet, dass** im zweiten Bereich neben der Übertragung von Bits mit alternativer Codierung zusätzlich auch Daten nach dem in der CAN-Norm ISO 11898-1 vorgesehenen Codierungsverfahren übertragen werden.

10. Verfahren gemäß einem der Ansprüche 1 bis 9,
**dadurch gekennzeichnet, dass** bei Vorliegen einer Umschaltbedingung neben dem Wechsel der Codierung der Bits auch ein Wechsel des Bustaktes in einem dritten vorgebbaren Bereich stattfindet, wobei der dritte Bereich vom zweiten Bereich umfasst wird oder mit dem zweiten Bereich übereinstimmt.

11. Verfahren gemäß Anspruch 10,
**dadurch gekennzeichnet, dass** der Wechsel des Bustaktes durch Verwendung mindestens zweier unterschiedlicher Skalierungsfaktoren zur Einstellung der Bus-Zeiteinheit relativ zu einer kleinsten Zeiteinheit oder dem Oszillatortakt im laufenden Betrieb realisiert wird.

12. Verfahren gemäß einem der Ansprüche 10 bis 11,
**dadurch gekennzeichnet, dass** im zweiten oder dritten Bereich der elektrische Widerstand zwischen den Busleitungen an das in dem Bereich angewendete Übertragungsverfahren angepasst wird.

13. Verfahren gemäß einem der Ansprüche 1 bis 12,
**dadurch gekennzeichnet, dass** der zweite Bereich von den Busteilnehmern unmittelbar nach Erkennung eines Grundes zum Start eines Error-Frames oder unmittelbar nach Erreichen eines für die Rückumschaltung festgelegten Bits endet und die Codierung der Bits in den Busteilnehmern wieder nach dem Verfahren des ersten Bereiches erfolgt.

14. Verfahren gemäß einem der Ansprüche 11 bis 13,
**dadurch gekennzeichnet, dass** der dritte Bereich von den Busteilnehmern unmittelbar nach Erkennung eines Grundes zum Start eines Error-Frames oder unmittelbar nach Erreichen eines für die Rückumschaltung festgelegten Bits endet und der Bustakt in den Busteilnehmern wieder auf den Wert des ersten Bereiches zurückgesetzt wird.

15. Verfahren gemäß einem der Ansprüche 1 bis 14,
**dadurch gekennzeichnet, dass** der Buszugriff durch die in der ISO 11898-1 beschriebene Arbitrierung vergeben wird, wobei der vorgebbare zweite Bereich, in welchem eine abweichende Codierung der Bits erfolgen kann, innerhalb der Nachricht frühestens mit dem ersten Bit des Data Length Code beginnt und spätestens mit dem Bit des CRC Delimiter endet.

16. Verfahren gemäß einem der Ansprüche 1 bis 15,
**dadurch gekennzeichnet, dass** das Vorliegen einer Umschaltbedingung den die Nachrichten austauschenden Datenverarbeitungseinheiten durch eine innerhalb des ersten vorgebbaren Bereiches liegende Kennzeichnung signalisiert wird.

17. Verfahren gemäß Anspruch 16, **dadurch gekennzeichnet, dass** die Kennzeichnung durch ein reserviertes Bit innerhalb des Control Field oder des Arbitration Field der Nachricht erfolgt.

18. Verfahren gemäß einem der Ansprüche 1 bis 14,
**dadurch gekennzeichnet, dass** der Buszugriff durch das in der ISO 11898-4 beschriebene, zeitgesteuerte Verfahren vergeben wird und der vorgebbare zweite Bereich, in welchem eine abweichende Codierung der Bits erfolgen kann, für vorgebbare Nachrichten innerhalb dieser Nachrichten frühestens mit dem Start of Frame Bit der Nachricht beginnt und spätestens mit dem Bit des CRC Delimiter endet.

19. Verfahren gemäß Anspruch 18,
**dadurch gekennzeichnet, dass** das Vorliegen einer Umschaltbedingung für die vorgebbaren Nachrichten im Rahmen der Konfiguration der zeitgesteuerten BusKommunikation festgelegt wird.

20. Verfahren gemäß einem der Ansprüche 18 bis 19,
**dadurch gekennzeichnet, dass** das Vorliegen einer Umschaltbedingung für die vorgebbaren Nachrichten den die Nachrichten austauschenden Datenverarbeitungseinheiten durch eine in der zuvor versendeten Referenzbotschaft liegende Kennzeichnung signalisiert wird.

21. Verfahren gemäß einem der Ansprüche 1 bis 20,
**dadurch gekennzeichnet, dass** der Übergang zum zweiten Bereich in den Busteilnehmern unmittelbar nach Erkennung der für die Umschaltung festgelegten Kennzeichnung oder des für die Umschaltung festgelegten Bits durchgeführt wird und die Codierung der Bits umgestellt wird.

22. Verfahren gemäß einem der Ansprüche 10 bis 12 und 14,
**dadurch gekennzeichnet, dass** der Übergang zum dritten Bereich in den Busteilnehmern unmittelbar nach Erkennung der für die Umschaltung festgelegten Kennzeichnung oder des für die Umschaltung festgelegten Bits durchgeführt wird und der Bustakt umgestellt wird.

23. Verfahren gemäß einem der vorangegangenen Ansprüche,
**dadurch gekennzeichnet, dass** das Kommunikationsprotokoll dahingehend verändert wird, dass sendende Busteilnehmer zumindest bei Vorliegen einer Umschaltbedingung gegenüber der Spezifikation ISO 11898-1 eine um ein Bit zu späte Bestätigung (Acknowledge) des korrekten Empfanges einer Nachricht durch einen oder mehrere Empfänger und / oder einen maximal zwei Bit langen Acknowledge-Slot akzeptieren und nicht als Fehler behandeln.

24. Vorrichtung zur Datenübertragung in einem Netzwerk mit mindestens zwei teilnehmenden Datenverarbeitungseinheiten und einer Verbindung zur Übertragung von Nachrichten,
**dadurch gekennzeichnet, dass** die Datenübertragung nach einem Verfahren gemäß einem der Ansprüche 1 bis 23 erfolgt.

25. Vorrichtung gemäß Anspruch 24,
**dadurch gekennzeichnet, dass** Mittel zur Ansteuerung einer Busanschlusseinheit oder einer Abschlusseinheit vorgesehen sind, wobei die Busanschlusseinheit oder die Abschlusseinheit durch die Ansteuerung an das verwendete Datenübertragungsverfahren angepasst werden kann.

26. Vorrichtung gemäß Anspruch 24,
**dadurch gekennzeichnet, dass** zumindest im Empfangszweig Anschlüsse zur Verbindung mit mehreren Busanschlusseinheiten vorgesehen sind, wobei die mehreren Busanschlusseinheiten zur Ausführung der unterschiedlichen verwendeten Datenübertragungsverfahren eingerichtet sind.

27. Busanschlusseinheit mit einer Vorrichtung nach Anspruch 24.

28. Busanschlusseinheit gemäß Anspruch 27,
**dadurch gekennzeichnet, dass** Mittel zur Anpassung der Busanschlusseinheit an das verwendete Datenübertragungsverfahren vorgesehen sind, wobei die Mittel wenigstens eine schaltbare Abschlusseinheit oder einen schaltbaren Widerstand umfassen.

## Claims

1. Method for data transmission in a network having at least two data processing units that interchange messages via the network, wherein the interchanged messages have a logical structure based on CAN specification ISO 11898-1,
wherein for at least one first prescribable area within the interchanged messages the bits are coded according to the method based on CAN standard ISO 11898-1,
**characterized in that** the presence of a changeover condition for at least one second prescribable area within the interchanged messages prompts the bits to be coded according to a method that differs from CAN standard ISO 11898-1.

2. Method according to Claim 1,
**characterized in that** the coding of the bits that is used in the second area is chosen such that increased safety in relation to external interference and/or lower emission of electromagnetic waves is achieved.

3. Method according to Claim 1 or 2,
**characterized in that** the coding used in the second area is NRZ coding, which has a smaller voltage swing in relation to the CAN standard and for which the recessive level is driven at low intensity.

4. Method according to Claim 1 or 2,
**characterized in that** NRZI coding is used in the second area for coding the bits, wherein the occurrence of a signal edge is interpreted as dominant and the absence of an edge is interpreted as recessive.

5. Method according to Claim 1 or 2,
**characterized in that** frequency modulation or frequency shift keying is applied in the second area for coding the bits, wherein a first frequency or group of frequencies or a first frequency range is interpreted as dominant and a second frequency or group of frequencies or a second frequency range is interpreted as recessive.

6. Method according to Claim 5,
**characterized in that** a third frequency or group of frequencies or a third frequency range is applied in the second area for signalling an identified error in the data transmission.

7. Method according to Claim 1 or 2,
**characterized in that** amplitude modulation or amplitude shift keying is applied in the second area for coding the bits, wherein a first amplitude or a first amplitude range is interpreted as dominant and a second amplitude or a second amplitude range is interpreted as recessive.

8. Method according to Claim 7,
**characterized in that** a third amplitude or a third amplitude range is applied in the second area for signalling an identified error in the data transmission.

9. Method according to one of Claims 1 to 8,
**characterized in that** besides the transmission of bits with alternative coding, additionally data according to the coding method provided in CAN standard ISO 11898-1 are also transmitted in the second area.

10. Method according to one of Claims 1 to 9,
**characterized in that** the presence of a changeover condition prompts not only the change in the coding of the bits but also a change in the bus clock to take place in a third prescribable area, wherein the third area is included by the second area or matches the second area.

11. Method according to Claim 10,
**characterized in that** the change in the bus clock is realized by using at least two different scaling factors for setting the bus time unit relative to a smallest time unit or to the oscillator clock in the course of operation.

12. Method according to either of Claims 10 and 11,
**characterized in that** in the second or third area the electrical resistance between the bus lines is matched to the transmission method applied in the area.

13. Method according to one of Claims 1 to 12,
**characterized in that** the second area of the bus subscribers ends immediately after identification of a reason for the start of an error frame or immediately after a bit stipulated for changing back over is reached, and the bits in the bus subscribers are again coded according to the method from the first area.

14. Method according to one of Claims 11 to 13,
**characterized in that** the third area of the bus subscribers ends immediately after identification of a reason for the start of an error frame or immediately after a bit stipulated for changing back over is reached, and the bus clock in the bus subscribers is reset to the value of the first area again.

15. Method according to one of Claims 1 to 14,
**characterized in that** bus access is allocated by the arbitration described in ISO 11898-1, wherein the prescribable second area, in which the bits can be coded differently, within the message begins no earlier than with the first bit of the data length code and ends no later than with the bit of the CRC delimiter.

16. Method according to one of Claims 1 to 15,
**characterized in that** the presence of a changeover condition is signalled to the data processing units interchanging the messages by a flag situated within the first prescribable area.

17. Method according to Claim 16,
**characterized in that** the flag is provided by a reserved bit within the control field or the arbitration field of the message.

18. Method according to one of Claims 1 to 14,
**characterized in that** bus access is allocated by the time-controlled method described in ISO 11898-4, and the prescribable second area, in which the bits can be coded differently, for prescribable messages, within these messages, begins no earlier than with the Start of Frame bit of the message and ends no later than with the bit of the CRC delimiter.

19. Method according to Claim 18,
**characterized in that** the presence of a changeover condition for the prescribable messages is stipulated as part of the configuration of the time-controlled bus communication.

20. Method according to either of Claims 18 and 19,
**characterized in that** the presence of a changeover condition for the prescribable messages is signalled to the data processing units interchanging the messages by a flag situated in the previously sent reference message.

21. Method according to one of Claims 1 to 20,
**characterized in that** the transition to the second area in the bus subscribers is made immediately after identification of the flag stipulated for the changeover or of the bit stipulated for the changeover, and the coding of the bits is converted.

22. Method according to one of Claims 10 to 12 and 14,
**characterized in that** the transition to the third area in the bus subscribers is made immediately after identification of the flag stipulated for the changeover or of the bit stipulated for the changeover, and the bus clock is converted.

23. Method according to one of the preceding claims,
**characterized in that** the communication protocol is altered such that sending bus subscribers are prompted at least by the presence of a changeover condition in relation to the specification ISO 11898-1 to accept an acknowledgement (Acknowledge) of the correct reception of a message by one or more receivers that is one bit too late and/or an Acknowledge slot with a maximum length of two bits and not to treat it/them as an error.

24. Apparatus for data transmission in a network having at least two participating data processing units and a connection for transmitting messages,
**characterized in that** the data transmission is effected according to a method according to one of Claims 1 to 23.

25. Apparatus according to Claim 24,
**characterized in that** means for actuating a bus connection unit or a termination unit are provided, wherein the bus connection unit or the termination unit can be matched to the data transmission method used by means of the actuation.

26. Apparatus according to Claim 24,
**characterized in that** at least the reception path contains connections for connection to a plurality of bus connection units, wherein the plurality of bus connection units are set up to carry out the different data transmission methods used.

27. Bus connection unit having an apparatus according to Claim 24.

28. Bus connection unit according to Claim 27,
**characterized in that** means for matching the bus connection unit to the data transmission method used are provided, wherein the means comprise at least a switchable termination unit or a switchable resistor.

## Revendications

1. Procédé de transmission de données dans un réseau comportant au moins deux unités de traitement de données échangeant des messages par l'intermédiaire du réseau, dans lequel les messages échangés présentent une structure logique conforme à la spécification CAN ISO 11898-1,
dans lequel, pour au moins une première région pouvant être prédéterminée à l'intérieur des messages échangés, le codage des bits est effectué conformément au procédé de la norme CAN ISO 11898-1,
**caractérisé en ce que**, lors de la présence d'une condition de basculement pour au moins une deuxième région pouvant être prédéterminée à l'intérieur des messages échangés, le codage des bits est effectué conformément à un procédé différent de la norme CAN ISO 11898-1.

2. Procédé selon la revendication 1, **caractérisé en ce que**, dans la deuxième région, le codage utilisé des bits est sélectionné de manière à obtenir une sécurité plus élevée vis-à-vis de perturbations externes et/ou un plus faible rayonnement d'ondes électromagnétiques.

3. Procédé selon la revendication 1 ou 2, **caractérisé en ce que**, dans la deuxième région, le codage utilisé est un codage NRZ qui présente une plus faible augmentation de tension par rapport à la norme CAN et dans le cadre duquel le niveau récessif est faiblement attaqué.

4. Procédé selon la revendication 1 ou 2, **caractérisé en ce que**, dans la deuxième région, pour le codage des bits, on utilise un codage NRZI, dans lequel l'apparition d'un front de signal prédominant et l'absence d'un front sont interprétées comme étant récessives.

5. Procédé selon la revendication 1 ou 2, **caractérisé en ce que**, dans la deuxième région, pour le codage des bits, on applique une modulation de fréquence ou une modulation par déplacement de fréquence, dans lequel une première fréquence ou un premier groupe de fréquences ou une première région de fréquences est interprété comme étant prédominant et une deuxième fréquence ou un deuxième groupe de fréquences ou une deuxième région de fréquences est interprété comme étant récessif.

6. Procédé selon la revendication 5, **caractérisé en ce que**, dans la deuxième région, on utilise une troisième fréquence ou un troisième groupe de fréquences ou une troisième région de fréquences destinés à la signalisation d'un défaut détecté dans la transmission de données.

7. Procédé selon la revendication 1 ou 2, **caractérisé en ce que**, dans la deuxième région, pour le codage des bits, on utilise une modulation d'amplitude ou une modulation par déplacement d'amplitude, dans lequel une première amplitude ou une première région d'amplitude est interprétée comme étant prédominante et une deuxième amplitude ou une deuxième région d'amplitude est interprétée comme étant récessive.

8. Procédé selon la revendication 7, **caractérisé en ce que**, dans la deuxième région, on utilise une troisième amplitude ou une troisième région d'amplitude destinée à la signalisation d'un défaut détecté dans la transmission de données.

9. Procédé selon l'une quelconque des revendications 1 à 8, **caractérisé en ce que**, dans la deuxième région, on transmet également, en plus de la transmission de bits, au moyen d'un codage différent, des données conformes au procédé de codage respectant la norme CAN ISO 11898-1.

10. Procédé selon l'une quelconque des revendications 1 à 9, **caractérisé en ce que**, lors de la présence d'une condition de basculement, en plus du changement de codage des bits, il se produit également un changement de fréquence du bus dans une troisième région pouvant être prédéterminée, dans lequel la troisième région est comprise dans la deuxième région ou concorde avec la deuxième région.

11. Procédé selon la revendication 10, **caractérisé en ce que** le changement de fréquence du bus est réalisé à chaud par utilisation d'au moins deux facteurs d'échelle différents pour régler l'unité de temps du bus par rapport à une unité de temps la plus petite ou à la fréquence de l'oscillateur.

12. Procédé selon l'une quelconque des revendications 10 à 11, **caractérisé en ce que**, dans la deuxième ou la troisième région, la résistance électrique entre les lignes de bus est adaptée au procédé de transmission utilisé dans ladite région.

13. Procédé selon l'une quelconque des revendications 1 à 12, **caractérisé en ce que** la deuxième région se termine par les utilisateurs de bus immédiatement après la détection d'une cause au début d'une trame d'erreur ou immédiatement après qu'un bit positionné pour le basculement inverse a été atteint et **en ce que** le codage des bits est effectué à nouveau dans les utilisateurs de bus conformément au procédé de la première région.

14. Procédé selon l'une quelconque des revendications 1 à 13, **caractérisé en ce que** la deuxième région se termine par les utilisateurs de bus immédiatement après la détection d'une cause au début d'une trame d'erreur ou immédiatement après qu'un bit positionné pour le basculement inverse a été atteint et **en ce que** la fréquence de bus est rétablie dans les utilisateurs de bus à la valeur de la première région.

15. Procédé selon l'une quelconque des revendications 1 à 14, **caractérisé en ce que** l'accès au bus est accordé par l'arbitrage décrit dans la norme ISO 11898-1, dans lequel la deuxième région pouvant être prédéterminée, dans laquelle un codage des bits différent peut être effectué, commence à l'intérieur du message au plus tôt par le premier bit du code de longueur de données et se termine au plus tard par le bit du délimiteur CRC.

16. Procédé selon l'une quelconque des revendications 1 à 15, **caractérisé en ce que** la présence d'une condition de basculement est signalée aux unités de traitement de données échangeant des messages par une identification située à l'intérieur de la première région pouvant être prédéterminée.

17. Procédé selon la revendication 16, **caractérisé en ce que** l'identification est effectuée par l'intermédiaire d'un bit réservé à l'intérieur du champ de contrôle ou du champ d'arbitrage du message.

18. Procédé selon l'une quelconque des revendications 1 à 14, **caractérisé en ce que** l'accès au bus est accordé par un procédé programmé décrit dans la norme ISO 11898-4 et **en ce que** la deuxième région pouvant être prédéterminée, dans laquelle un codage différent des bits peut être effectué, commence, pour des messages pouvant être prédéterminés, à l'intérieur dudit message au plus tôt par le bit de début de trame du message et se termine au plus tard par le bit du délimiteur CRC.

19. Procédé selon la revendication 18, **caractérisé en ce que** la présence d'une condition de basculement pour les messages pouvant être prédéterminés est établie dans le cadre de la configuration de la communication de bus programmée.

20. Procédé selon l'une quelconque des revendications 18 à 19, **caractérisé en ce que** la présence d'une condition de basculement pour les messages pouvant être prédéterminés est signalée aux unités de traitement de données échangeant des messages par l'intermédiaire d'une identification située dans le message de référence préalablement émis.

21. Procédé selon l'une quelconque des revendications 1 à 20, **caractérisé en ce que** le passage à la deuxième région est effectué dans les utilisateurs de bus immédiatement après la détection de l'identification établie pour le basculement ou du bit positionné pour le basculement et **en ce qu'**un changement de codage des bits est effectué.

22. Procédé selon l'une quelconque des revendications 10 à 12 et 14, **caractérisé en ce que** le passage à la troisième région est effectué dans les utilisateurs de bus immédiatement après la détection de l'identification établie pour le basculement ou du bit positionné pour le basculement et **en ce qu'**un changement de fréquence de bus est effectué.

23. Procédé selon l'une quelconque des revendications précédentes, **caractérisé en ce que** le protocole de communication est modifié en faisant en sorte que des utilisateurs de bus émetteurs, au moins lors de la présence d'une condition de basculement par rapport à la spécification ISO 11898-1, acceptent un acquittement (Acknowledge) retardé d'un bit de la réception correcte d'un message par un ou plusieurs récepteurs et/ou un créneau d'accusé de réception d'une longueur maximale de deux bits et ne les traitent pas comme étant des erreurs.

24. Dispositif de transmission de données dans un réseau comportant au moins deux unités de traitement de données raccordées et une liaison destinée à la transmission de messages, **caractérisé en ce que** la transmission de données est effectuée conformément à un procédé selon l'une quelconque des revendications 1 à 23.

25. Dispositif selon la revendication 24, **caractérisé en ce qu'**il est prévu des moyens destinés à commander une unité de raccordement de bus ou une unité de terminaison, dans lequel l'unité de raccordement de bus ou l'unité de terminaison peuvent être adaptées par la commande au procédé de transmission de données utilisé.

26. Dispositif selon la revendication 24, **caractérisé en ce qu'**au moins dans la branche de réception, il est prévu des raccords destinés à établir une liaison à de multiples unités de raccordement de bus, dans lequel les multiples unités de raccordement de bus sont conçues pour mettre en oeuvre les différents procédés de transmission de données utilisés.

27. Unité de raccordement de bus comportant un dispositif selon la revendication 24.

28. Unité de raccordement de bus selon la revendication 27, **caractérisée en ce qu'**il est prévu des moyens destinés à adapter l'unité de raccordement de bus aux procédés de transmission de données utilisés, dans lequel les moyens comprennent au moins une unité de terminaison commutable ou une résistance pouvant être connectée.
